# EUROPEAN PATENT APPLICATION

(11) **EP 4 621 337 A1**
(43) Date of publication of application: **24.09.2025**
(21) Application number: 25164684.0
(22) Date of filing: 19.03.2025
(51) Int. Cl.: F28F 3/02, H01M 10/613, H01M 10/6551, H01M 10/6567, H05K 7/20

(54) **LIQUID COOLING ASSEMBLY**

(30) Priority: 20.03.2024 TW 113202776 U
(71) Applicant: Cooler Master Co., Ltd., Taipei City 114065 (TW)
(72) Inventor: LIN, CHIA-YU, 114065 Taipei City (TW); LIEN, KUO-CHEN, 114065 Taipei City (TW); TU, PO-WEN, 114065 Taipei City (TW)
(74) Representative: Grünecker Patent- und Rechtsanwälte PartG mbB

(57) **Abstract**

A liquid cooling assembly thermally coupled to multiple heat sources, includes a first heat dissipation assembly including a first base having a first thermal contact surface and a first inner surface positioned opposite to one another, the first thermal contact surface is thermally coupled to one of the heat sources, and a plurality of first fins protrude from the first inner surface, a second heat dissipation assembly including a second base have a second thermal contact surface and a second inner surface positioned opposite to one another, the first thermal contact surface is thermally coupled to one of the heat sources, the first inner surface and the second inner surface are facing toward to each other, and a plurality of second fins protrude from the second inner surface, and a splitter disposed between the first and the second heat dissipation assembly, ends of the first fins and the second fins are connected to the splitter.

## Description

### TECHNICAL FIELD

The present disclosure is related to the field of a heat dissipation device, more particularly to a heat dissipation device having fins.

### BACKGROUND

With the rapid development of science and technology, computers have progressively become an absolute necessity in people's life. The processing speed and performance of electronic devices such as display adapters and processors in computers are gradually improving. During operation, a large amount of heat will be generated, which may cause the electronic devices to overheat and reduce performance or may even cause the electronic devices to be damaged due to the continuous increase in temperature.

In order to improve the heat dissipation effect of electronic devices, a liquid cooling system is usually used to dissipate heat from electronic components. The conventional liquid cooling system is mainly composed of a liquid cooling head, a liquid cooling radiator and a pump. The liquid cooling radiator contains heat dissipation fins. Changing the shape of the heat dissipation fins or increasing the size of the heat dissipation fins can increase the heat exchange area and improve the heat dissipation efficiency of the liquid cooling system. However, large-sized heat dissipation fins are prone to deformation during manufacturing, resulting in a weaker product structure or poor performance. Therefore, enhancing the manufacturing yield of heat dissipation fins while preserving optimal heat dissipation efficiency has emerged as a challenge that researchers in this field are committed to addressing.

### SUMMARY

The invention is as as defined in the appended claims. Aspects of the disclosure provide a liquid cooling assembly being configured to thermally couple to a plurality of heat sources. The liquid cooling assembly includes a first heat dissipation assembly, a second heat dissipation assembly, and a splitter. The first heat dissipation assembly includes a first base having a first thermal contact surface and a first inner surface positioned opposite to one another, the first thermal contact surface is configured to thermally couple to one of the plurality of heat sources, and a plurality of first fins protrude from the first inner surface. The second heat dissipation assembly includes a second base have a second thermal contact surface and a second inner surface positioned opposite to one another, the second thermal contact surface is configured to thermally couple to one of the plurality of heat sources, the first inner surface and the second inner surface are facing toward to each other, and a plurality of second fins protrude from the second inner surface. The splitter is disposed between the first heat dissipation assembly and the second heat dissipation assembly, ends of the first fins that are away from the first base and ends of the second fins that are away from the second base are connected to the splitter.

In an embodiment, the first heat dissipation assembly can include two sidewalls, each connects between opposite ends of the first heat dissipation assembly and the second inner surface of the second heat dissipation assembly.

In an embodiment, the first fins are parallel to the sidewalls and a first cooling channel is formed between each two adjacent first fins, the second fins are parallel to the sidewalls and a second cooling channel is formed between each two adjacent second fins, and the splitter prevents the first cooling channel to connect with the second cooling channel.

In an embodiment, the first cooling channel and the second cooling channel are configured to accompany a cooling fluid.

In an embodiment, the ends of the first fins that are away from the first base and the ends of the second fins that are away from the second base are soldered to respective opposite surfaces of the splitter.

In an embodiment, each of the first fins has a first bended end that is away from the first base, each of the second fins has a second bended end that is away from the second base, and the first fins and the second fins are soldered to the splitter at the first bended ends and the second bended ends respectively.

In an embodiment, the sidewalls are soldered to the second inner surface of the second heat dissipation assembly. In an embodiment, the first fins and the second fins are skived fins.

In an embodiment, the splitter are made of copper. In an embodiment, the first fins and the first base are integrated as one single structure, and the second fins and the second base are integrated as one single structure.

### BRIEF DESCRIPTION OF DRAWINGS

Aspects of the present disclosure can be understood from the following detailed description when read with the accompanying figures. It is noted that, in accordance with the standard practice in the industry, various features are not drawn to scale. In fact, the dimensions of the various features may be increased or reduced for clarity of discussion.
Fig. 1 illustrates a perspective view of a liquid cooling assembly 10 according to aspects of the present disclosure.
Fig. 2 illustrates an exploded view of the liquid cooling assembly 10 as shown in Fig. 1.
Fig. 3 illustrates a front view of the liquid cooling assembly 10 as shown in Fig. 1.
Fig. 4 illustrates a perspective cross-section view of the liquid cooling assembly 10 along the AA cutline as shown in Fig. 3.
Fig. 5 illustrates a front view of a liquid cooling assembly 10A according to aspects of the present disclosure.

### DETAILED DESCRIPTION

Detailed descriptions and technical contents of the present invention are illustrated below in conjunction with the accompanying drawings. However, it is to be understood that the descriptions and the accompanying drawings disclosed herein are merely illustrative and exemplary and not intended to limit the scope of the present invention.

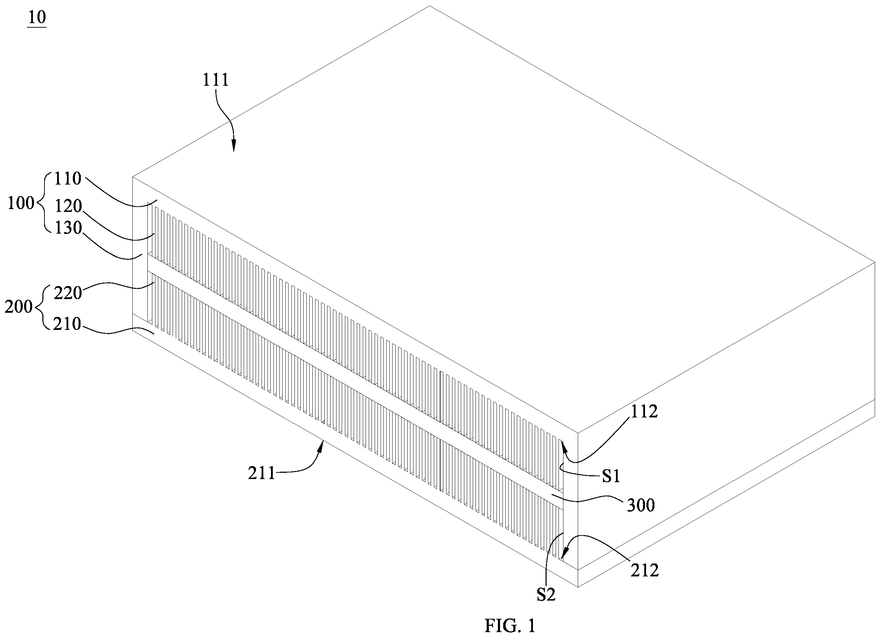

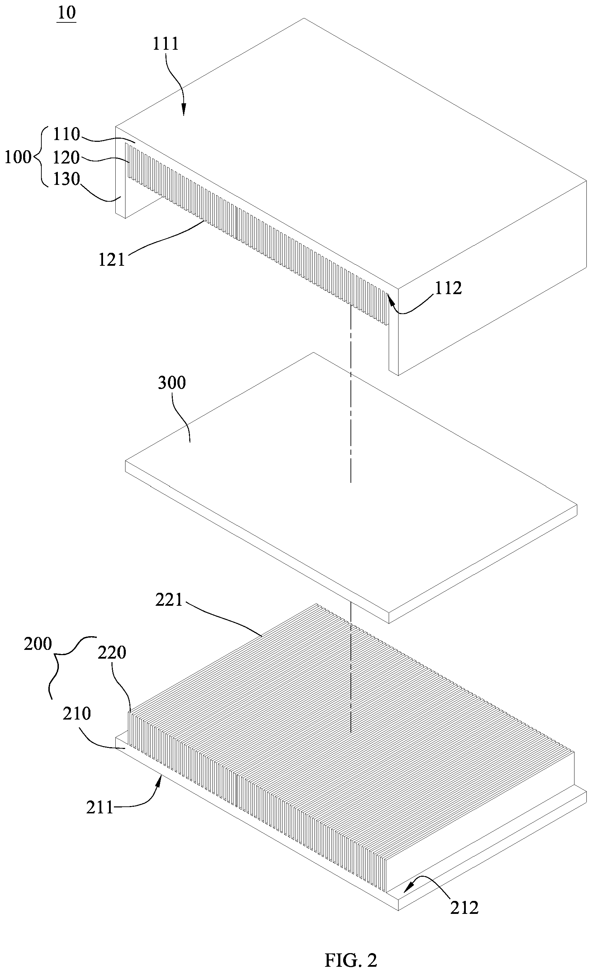

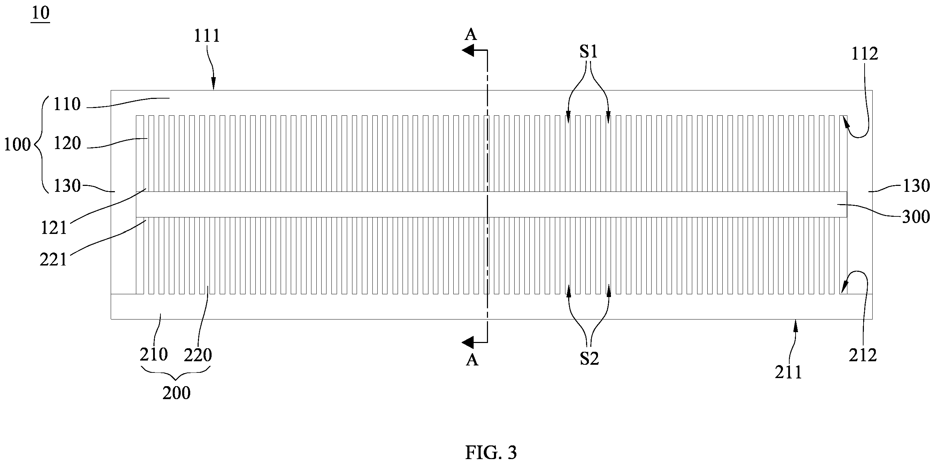

Referring to Figs. 1 to 3. Fig. 1 illustrates a perspective view of a liquid cooling assembly 10 according to aspects of the present disclosure. Fig. 2 illustrates an exploded view of the liquid cooling assembly 10 as shown in Fig. 1. Fig. 3 illustrates a front view of the liquid cooling assembly 10 as shown in Fig. 1.

The liquid cooling assembly 10 can be thermally coupled to multiple heat sources (not shown). The liquid cooling assembly 10 includes a first heat dissipation assembly 100, a second heat dissipation assembly 200, and a splitter 300. The first heat dissipation assembly 100 includes a base 110 and a plurality of fins 120. The base 110 has a thermal contact surface 111 and an inner surface 112 that are opposite to each other. The thermal contact surface 111 can be coupled to a heat source (not shown). The fins 120 are protruded from the inner surface 112 in a direction away from the inner surface 112. Similar to the first heat dissipation assembly 100, the second heat dissipation assembly 200 includes a base 210 and a plurality of fins 220. The base 120 has a thermal contact surface 211 and an inner surface 212 that are opposite to each other. The thermal contact surface 211 can be coupled to a heat source (not shown). The fins 220 are protruded from the inner surface 212 in a direction away from the inner surface 212.

In one embodiment, the fins 120 and 220 can be skived fins. Namely, the fins 120 and the base 110 and the fins 220 and the base 210 are integrally formed together respectively. In some embodiments, the fins can be different type. For example, the fins can be bonded fins or aluminum extruded fins. In some embodiments, the fins of the first heat dissipation assembly can be the same type as the fins of the second heat dissipation assembly. In some embodiments, the fins of the first heat dissipation assembly can be a different type than the fins of the second heat dissipation assembly.

The first heat dissipation assembly 100 can further include two sidewalls 130. The two sidewalls 130 are connected with the inner surface 112, extend in a direction away from the inner surface 112, and connect to the inner surface 212 of the second heat dissipation assembly 200. The fins 120 and 220 are located between the two sidewalls 130 and are parallel to the two sidewalls 130. Namely, each sidewall 130 is connecting the respective ends of the first heat dissipation assembly 100 and the second heat dissipation assembly 200. In an embodiment, the sidewalls 130 can be integrally formed with the first heat dissipation assembly 100 so that the first heat dissipation assembly 100 is a U-shaped structure. In some embodiments, the sidewalls 130 can be soldered to both of the inner surface 112 of the first heat dissipation assembly 100 and the inner surface 212 of the second heat dissipation assembly 200.

The splitter 300 is disposed between the first heat dissipation assembly 100 and the second heat dissipation assembly 200. Specifically, the splitter 300 is disposed between the fins 120 of the first heat dissipation assembly 100 and the fins 220 of the second heat dissipation assembly 200. In addition, the splitter 300 is disposed between the two sidewalls 130 and connects to the two sidewalls 130. Each fin 120 has an end 121 that is connect to the splitter 300, and each fin 220 has an end 221 that is connect to the splitter 300. The ends 121 and ends 221 can be soldered to the respective surface of the splitter 300. In this way, cooling channels S1 are formed between each two adjacent fins 120 of the first heat dissipation assembly 100 as well as between the outermost fins 120 and the sidewalls 130. Similarly, cooling channels S2 are formed between each two adjacent fins 220 of the second heat dissipation assembly 200 as well as between the outermost fins 220 and the sidewalls 130. Further, the cooling channels S1 and cooling channels S2 are separated by the splitter 300. The splitter 300 can be made of various material that has a good thermal conductivity. For example, the splitter 300 can be made of copper, aluminum, gold, or sliver, or any combinations of the foregoing materials.

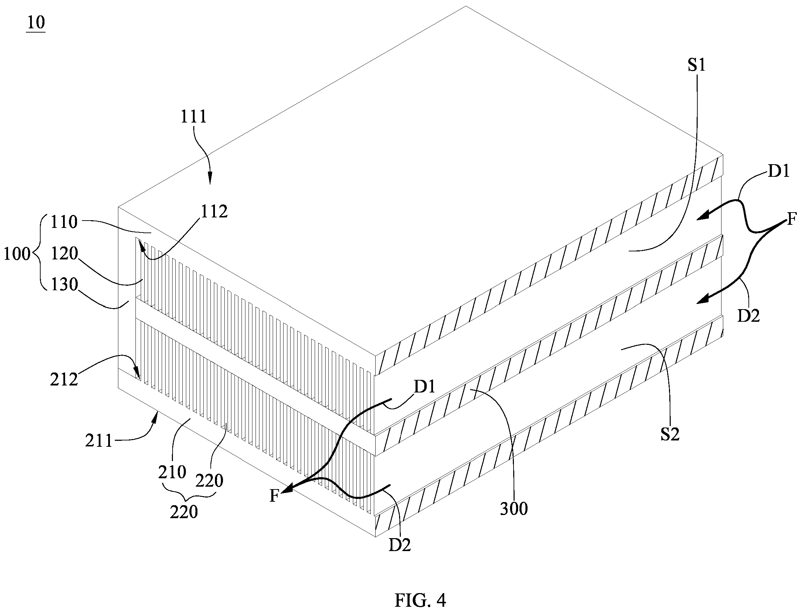

Referring to Fig. 4, which illustrates a perspective cross-section view of the liquid cooling assembly 10 along the AA cutline as shown in Fig. 3. The liquid cooling assembly 10 is configured to have a cooling fluid F flow through cooling channels S1 and S2. The cooling fluid F can be split by the splitter 300 into two paths. One path, the cooling fluid F flows through the cooling channels S1 in the direction D1. The other path, the cooling fluid F flows through the cooling channels S2 in the direction D2. In this way, the cooling fluid F can simultaneously dissipate the heat of the heat sources coupled to the thermal contact surfaces 111 and 211, and in turn, enhance the heat dissipation efficiency of the liquid cooling assembly 10.

By utilizing a splitter in a liquid cooling assembly, a long fin between the first heat dissipation assembly and the second heat dissipation assembly can be replaced by two shorter fins that are disposed between the first heat dissipation assembly and the splitter and between the second heat dissipation assembly and the splitter. Shorter fins can decrease the possibility of deformation during manufacturing, which, in turn enhance the yield rate of the fins.

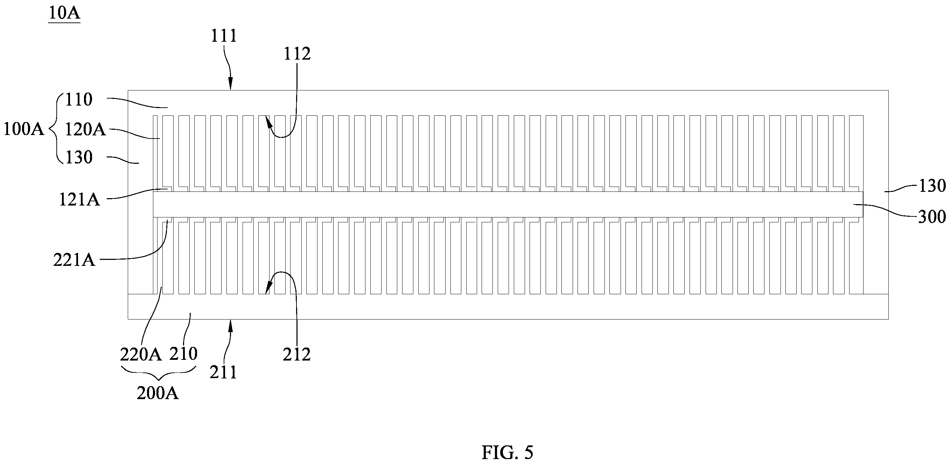

Referring to Fig. 5, which illustrates a front view of a liquid cooling assembly 10A according to aspects of the present disclosure. The liquid cooling assembly 10A is similar to the liquid cooling assembly 10 as shown in Fig. 1. Therefore, only the differences between the liquid cooling assembly 10A and the liquid cooling assembly 10 will be discussed below. Specifically, the liquid cooling assembly 10A includes a plurality of fins 120A of the first heat dissipation assembly 100A and a plurality of fins 220A of the first dissipation assembly 200A. Each of the fins 120A further includes a bended end 121A and each of the fins 220A further include a bended end 221A. The fins 120A and 220A are connect to the splitter 300 at the respective bended ends 121A and 221A. The bended ends 121A and 221A provide a larger contact area for connecting to the splitter 300. For example, the bended ends 121A and 221A provide a larger contact area for soldering. In addition, a larger soldering contact area can result a higher soldering strength, which, in turn can prevent the deformation of the fins during manufacturing.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners apparent to those of ordinary skill in the relevant art having the benefit of the teachings herein. Furthermore, no limitations are intended to the details of construction or design herein shown, other than as described in the claims below. It is therefore evident that the particular illustrative embodiments disclosed above may be altered, combined, or modified and all such variations are considered within the scope and spirit of the present disclosure.

The embodiments illustratively disclosed herein suitably may be practiced in the absence of any element that is not specifically disclosed herein and/or any optional element disclosed herein. While compositions and methods are described in terms of "comprising," "containing," or "including" various components or steps, the compositions and methods can also "consist essentially of" or "consist of" the various components and steps. All numbers and ranges disclosed above may vary by some number. Whenever a numerical range with a lower limit and an upper limit is disclosed, any number and any included range falling within the range is specifically disclosed. In particular, every range of values (of the form, "from about a to about b," or, equivalently, "from approximately a to b," or, equivalently, "from approximately a-b") disclosed herein is to be understood to set forth every number and range encompassed within the broader range of values. Also, the terms in the claims have their plain, ordinary meaning unless otherwise explicitly and clearly defined by the patentee. Moreover, the indefinite articles "a" or "an," as used in the claims, are defined herein to mean one or more than one of the elements that it introduces.

## Claims

1. A liquid cooling assembly (10) being configured to thermally couple to a plurality of heat sources, comprising:
a first heat dissipation assembly (100), comprising:
a first base (110) having a first thermal contact surface (111) and a first inner surface (112) positioned opposite to one another, the first thermal contact surface (111) is configured to thermally couple to one of a plurality of heat sources; and
a plurality of first fins (120) protrude from the first inner surface (112);
a second heat dissipation assembly (200), comprising:
a second base (210) have a second thermal contact surface (211) and a second inner surface (212) positioned opposite to one another, the second thermal contact surface (211) is configured to thermally couple to one of the plurality of heat sources, the first inner surface (112) and the second inner surface (212) are facing toward to each other; and
a plurality of second fins (220) protrude from the second inner surface (212); and
a splitter (300) disposed between the first heat dissipation assembly (100) and the second heat dissipation assembly (200), ends (121) of the first fins (120) that are away from the first base (110) are connected to the splitter (300), and ends (221) of the second fins (220) that are away from the second base (210) are connected to the splitter (300).

2. The liquid cooling assembly (10) of claim 1, wherein the first heat dissipation assembly (100) includes two sidewalls (130), each connects between opposite ends of the first heat dissipation assembly (100) as well as the second inner surface (212) of the second heat dissipation assembly (200).

3. The liquid cooling assembly (10) of claim 2, wherein the first fins (120) are parallel to the sidewalls (130) and a first cooling channel (S1) is formed between each two adjacent first fins (120), the second fins (220) are parallel to the sidewalls (130) and a second cooling channel (S2) is formed between each two adjacent second fins (220), and the splitter (300) prevents the first cooling channel (S1) from connecting with the second cooling channel (S2).

4. The liquid cooling assembly (10) of claim 3, wherein the first cooling channel (S1) and the second cooling channel (S2) are configured to accompany a cooling fluid (F).

5. The liquid cooling assembly (10) of one of claims 1 to 4, wherein the ends (121) of the first fins (120) that are away from the first base (110) and the ends (221) of the second fins (220) that are away from the second base (210) are soldered to respective opposite surfaces of the splitter (300).

6. The liquid cooling assembly (10A) of one of claims 1 to 5, wherein each of the first fins (120A) has a first bended end (121A) that is away from the first base (110), each of the second fins (220A) has a second bended end (221A) that is away from the second base (210), and the first fins (120A) and the second fins (220A) are soldered to the splitter (300) at the first bended ends (121A) and the second bended ends (221A) respectively.

7. The liquid cooling assembly (10) of one of claims 2 to 6, wherein the sidewalls (130) are soldered to the second inner surface (212) of the second heat dissipation assembly (200).

8. The liquid cooling assembly (10) of one of claims 1 to 7, wherein the first fins (120) and the second fins (220) are skived fins.

9. The liquid cooling assembly (10) of one of claims 1 to 8, wherein the splitter (300) are made of copper.

10. The liquid cooling assembly (10) of one of claims 1 to 9, wherein the first fins (120) and the first base (110) are integrated as one single structure, and the second fins (220) and the second base (210) are integrated as one single structure.
